# EUROPEAN PATENT APPLICATION

(11) **EP 1 111 659 A2**
(43) Date of publication of application: **27.06.2001**
(21) Application number: 00310460.1
(22) Date of filing: 24.11.2000
(51) Int. Cl.: H01L 21/00

(54) **Apparatus and methods of chemical mechanical polishing**

(30) Priority: 24.11.1999 US 167412 P; 21.11.2000 US 721047
(71) Applicant: Applied Materials, Inc., Santa Clara, California 95054 (US)
(72) Inventor: Somekh, Sasson, Los Altos Hills, CA94022 (US)
(74) Representative: Bayliss, Geoffrey Cyril

(57) **Abstract**

A chemical mechanical polishing apparatus has a plurality of polishing stations (20) and a cleaning station (60). The cleaning station includes a cleaning module (62) to clean a wafer and a buffing module (70) to buff the wafer prior to cleaning in the cleaning module.

## Description

The present invention relates generally to chemical mechanical polishing of substrates, and more particularly to methods and apparatus for cleaning and buffing a substrate after chemical mechanical polishing.

An integrated circuit is typically formed by the sequential deposition of conductive, semiconductive or insulative layers on a silicon wafer. One fabrication step involves depositing a filler layer over a non-planar surface, and planarizing the filler layer until the non-planar surface is exposed. For example, a conductive filler layer can be deposited on a patterned insulative layer to fill the trenches or holes in the insulative layer. The filler layer is then polished until the raised pattern of the insulative layer is exposed. After planarization, the portions of the conductive layer remaining between the raised pattern of the insulative layer form vias, plugs and lines that provide conductive paths between thin film circuits on the wafer. In addition, planarization is needed to planarize the wafer surface for photolithography.

Chemical mechanical polishing (CMP) is one accepted method of planarization. This planarization method typically requires that the wafer be mounted on a carrier or polishing head. The exposed surface of the wafer is placed against a rotating polishing disk pad or belt pad. The polishing pad can be either a "standard" pad or a fixed-abrasive pad. A standard pad has a durable roughened surface, whereas a fixed-abrasive pad has abrasive particles held in a containment media. The carrier head provides a controllable load on the wafer to push it against the polishing pad. A polishing slurry, including at least one chemically-reactive agent, and abrasive particles if a standard pad is used, is supplied to the surface of the polishing pad.

After the primary polishing step, the wafer is typically buffed to reduce defects. A conventional buffing step uses a softer polishing pad and a lower pressure than the primary polishing step. Following the buffing, the wafer can be cleaned, e.g., with megasonic cleaners, scrub brushes, or the like.

In one aspect, the invention is directed to a chemical mechanical polishing apparatus. The apparatus has a plurality of polishing stations and a cleaning station. The cleaning station includes a cleaning module to clean a wafer and a buffing module to buff the wafer prior to cleaning in the cleaning module.

Implementations of the invention may include one or more of the following features. The buffing module may include a buffing pad that is movable, e.g., rotatable, relative to the wafer, and may include a rotatable wafer support. The buffing pad may be about the same diameter as the wafer. A wafer transport apparatus may carry wafers from the polishing stations to the cleaning station, and a controller may be operable to cause the wafer to be polished at one of the polishing stations, transported to the buffing module in the cleaning station, and buffed in the buffing module. The cleaning station may include a second wafer transport apparatus to transport wafers from the buffing module to the cleaning module, and the controller may be operable to cause the wafer to be transported from the buffing module to the cleaning module, and be cleaned in the cleaning module. The cleaning module may include a brush scrubber or a spin-rinse drier.

In another aspect, the invention is directed to a method of chemical mechanical polishing. A wafer is polished at one of two or more polishing stations, transported into a cleaning station, buffed in the cleaning station with a buffing pad, and cleaned in the cleaning station.

Implementations of the invention may include the following feature. The buffing step may be significantly shorter than the polishing step.

In another aspect, the invention is directed to a method of chemical mechanical polishing, in which a plurality of wafers are polished simultaneously at a plurality of polishing stations. The wafers are transported in series into a cleaning station, buffed in series in the cleaning station with a buffing pad, and cleaned in series in the cleaning station.

Implementations of the invention may include one or more of the following features. Each of the plurality of wafers may be polished to completion at one of the polishing stations before being transported to the cleaning station, or a substantially equal portion of the polishing of a wafer may be performed at each polishing station before the wafer is transported to the cleaning station.

A possible advantage of the invention is improved throughput.

The details of one or more embodiments of the invention are set forth in the accompanying drawings and the description below. Other features, objects, and advantages of the invention will be apparent from the description and drawings, and from the claims.

Figure 1 is a schematic top view of a polishing apparatus with two polishing stations and a cleaning and buffing station.

Figure 2 is a side view of a buffing device.

Like reference symbols in the various drawings indicate like elements.

Some CMP machines include multiple polishing stations to perform multiple polishing or buffing operations in parallel. The invention can improve throughput in such a polishing machine by performing wafer buffing outside the primary polishing stations, e.g., in a cleaning station. This permits all of the primary polishing stations in the CMP machine to be used for polishing, thereby increasing throughput.

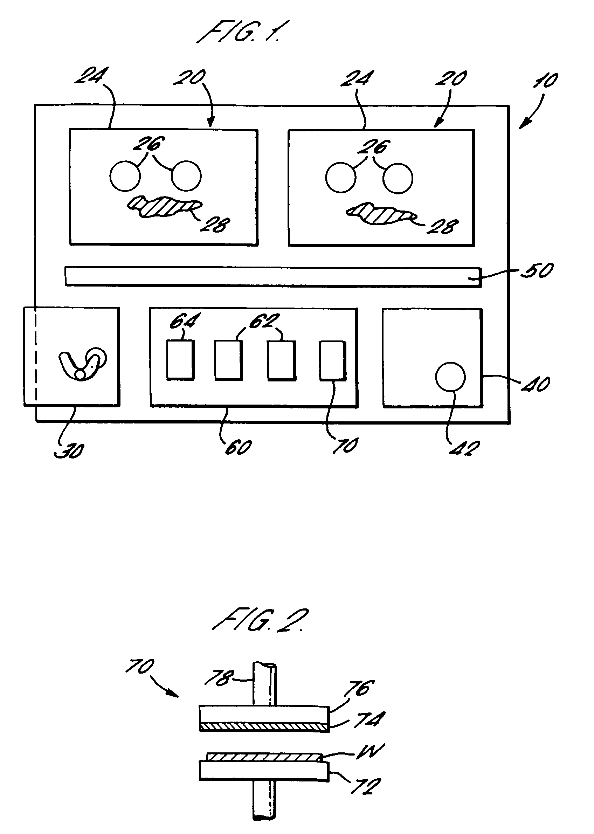

Figure 1 shows a chemical mechanical polishing (CMP) apparatus 10 that includes two polishing stations 20. Each polishing station includes a platen 24 to which a polishing pad, such as a conventional durable polishing pad or a fixed-abrasive pad with abrasive particles embedded in a containment media, is secured. Although illustrated as generally rectangular, each platen can be fixed or rotatable, and each polishing pad can be affixed to the platen, an advanceable web, or a linear belt. In addition, although two polishing stations are shown, the CMP apparatus can include three or more polishing stations. Furthermore, the stations can be arranged linearly, in a cluster, or in some other configuration.

One or more carrier heads 26 are positioned above the polishing stations, with each carrier head 26 holding a wafer against one of the polishing pads with a controllable load. Relative motion between the polishing pad and the wafer can be provided by motion of the polishing pad, e.g., rotational or orbital motion of the platen with a secured polishing pad or linear motion of a polishing belt, by motion of the carrier, e.g., rotational, orbital or lateral oscillation, or by motion of both the carrier and the polishing pad. A polishing liquid 28, which need not contain abrasive particles if a fixed-abrasive polishing pad is used, is supplied to the surface of the polishing pad.

The CMP apparatus 10 also includes a wafer transfer station 30, an optional metrology station 40, and a wafer transport apparatus 50 to move the wafers between the polishing stations 20, the wafer transfer station 30, and the optional metrology station 40. The wafer transfer station 30 is preferably a dry-in dry-out station, although it could be a dry-in wet-out or wet-in wet-out station. The metrology station 40 can include a conventional metrology tool 42 to measure the polishing uniformity and wafer defects of the wafers from the polishing stations 20. The wafer transport apparatus 50 is shown as extending linearly across the polishing apparatus, but it can also be a rotatable carousel.

The CMP apparatus 10 also includes a combined cleaning and buffing station 60. Wafers can be transported from the metrology station 40 (or from the wafer transport apparatus 50 if the metrology station 40 is not present) to the wafer transfer station 30 through the cleaning and buffing station 60. Wafers could be loaded from the metrology station 40 into the combined cleaning and buffing station 60 by the wafer transport apparatus 50, or by a robot inside the combined cleaning and buffing station 60. The cleaning and buffing station 60 includes one or more washing modules 62, such as a brush scrubber or megasonic cleaner, and one or more drying modules 64, such as a spin-rinse drier, to clean and dry the wafer.

The cleaning and buffing station 60 also includes an initial buffing module 70. As shown in Figure 2, the buffing module 70 includes a wafer support 72 and a rotatable buffing pad 74 which can moved into contact with the wafer. In contrast to the polishing pads 24 in the polishing stations 20, the buffing pad 74 can be relatively small, e.g., about the same diameter as the wafer. In some polishing operations, only a relatively small amount of buffing is required, e.g., a few seconds, as compared a relatively longer amount of polishing, e.g., several minutes, that is required at the polishing stations 20. The combined cleaning and buffing station 60 is particularly useful in such operations, because if one of the polishing stations 20 is used for buffing, that station will sit idle waiting for the wafer to be polished at the other polishing station, thereby decreasing throughput. In contrast, if both polishing stations are use for regular polishing, the throughput of the polishing apparatus can practically double. In addition, since the buffing pad 74 is relatively small, it can fit into the cleaning and buffing station 60, and does not require a dedicated station.

As illustrated, the buffing pad 74 can be attached to a rotatable backing plate 76 that is connected to an unillustrated motor by a drive shaft 78. Alternatively, the buffing pad can remain motionless and the wafer W can be rotated by the wafer support 72. A relative rotation rate of about 30 rpm to 200 rpm should be appropriate for the buffing pad 74. Relative motion between the buffing pad and wafer can be created by rotation of either the backing plate 76 or the wafer support 72, or both, and the pressure of the buffing pad 74 on the wafer can be created by vertical actuation of either the backing plate 76 or the wafer support 72, or both. Although illustrated with the wafer W below the buffing pad 74, the buffing module can have other orientations.

The CMP apparatus is operated by a controller, such as a programmable digital computer, that coordinates the operation of the various wafer transport devices. The controller is operable to cause the wafer to be polished at one of the polishing stations, transported to the cleaning station, buffed in the buffing module, and cleaned in the cleaning module. The CMP apparatus can operate is a serial polishing mode, in which a substantially equal portion of the polishing of a wafer is performed at each polishing station, or in a parallel polishing mode, in which a wafer is polished to completion at one of the polishing stations, and then transported to the combined cleaning and buffing station 60 without being polished at the other polishing station or stations.

A number of embodiments of the invention have been described. Nevertheless, it will be understood that various modifications may be made without departing from the spirit and scope of the invention. Accordingly, other embodiments are within the scope of the following claims.

## Claims

1. A chemical mechanical polishing apparatus, comprising:
a plurality of polishing stations; and
a cleaning station, wherein the cleaning station includes a cleaning module to clean a wafer and a buffing module to buff the wafer prior to cleaning in the cleaning module.

2. An apparatus as claimed in claim 1, wherein the buffing module includes a buffing pad that is movable relative to the wafer.

3. An apparatus as claimed in claim 2, wherein the buffing pad is about the same diameter as the wafer.

4. An apparatus as claimed in claim 2 or claim 3, wherein the buffing paid is rotatable.

5. An apparatus as claimed in any of claims 1 to 4, wherein the buffing module includes a rotatable wafer support.

6. An apparatus as claimed in any of claims 1 to 5, further comprises a wafer transport apparatus to carry wafers from the polishing stations to the cleaning station, and a controller operable to cause the wafer to be polished at one of the polishing stations, transported to the buffing module in the cleaning station, and buffed in the buffing module.

7. An apparatus as claimed in claim 6, wherein the cleaning station includes a second wafer transfer apparatus to transport wafers from the buffing module to the cleaning module.

8. An apparatus as claimed in claim 7, wherein the controller is operable to cause the wafer to be transported from the buffing module to the cleaning module, and be cleaned in the cleaning module.

9. An apparatus as claimed in any of claims 1 to 8, wherein the cleaning module includes a brush scrubber.

10. An apparatus as claimed in claim 9, wherein the cleaning module includes a spin-rinse drier.

11. A method of chemical mechanical polishing, comprising:
polishing a wafer at one of two or more polishing stations;
transporting the wafer into a cleaning station;
buffing the wafer in the cleaning station with a buffing pad; and
cleaning the wafer in the cleaning station.

12. A method as claimed in claim 11, wherein the buffing step is significantly shorter than the polishing step.

13. A method of chemical mechanical polishing, comprising:
simultaneously polishing a plurality of wafers at a plurality of polishing stations;
transporting the wafers in series into a cleaning station;
buffing the wafers in series in the cleaning station with a buffing pad; and
cleaning the wafers in series in the cleaning station.

14. A method as claimed in claim 13, wherein each of the plurality of wafers is polished to completion at one of the polishing stations before being transported to the cleaning station.

15. A method as claimed in claim 13, wherein a substantially equal portion of the polishing of a wafer is performed at each polishing station before the wafer is transported to the cleaning station.
